# EUROPEAN PATENT APPLICATION

(11) **EP 4 845 345 A1**
(43) Date of publication of application: **25.11.2026**
(21) Application number: 25823706.4
(22) Date of filing: 11.07.2025
(51) Int. Cl.: H10F 19/00, H10F 77/70, H10F 77/48

(54) **PHOTOVOLTAIC CELL, MODULE, AND SYSTEM**

(30) Priority: 21.01.2025 CN 202510089067
(71) Applicant: Zhejiang Aiko Solar Energy Technology Co., Ltd., Jinhua, Zhejiang 322009 (CN); Guangdong Aiko Solar Energy Technology Co., Ltd., Foshan, Guangdong 528000 (CN); Tianjin Aiko Solar Energy Technology Co., Ltd., Tianjin 300400 (CN); Zhuhai Fushan Aiko Solar Energy Technology Co., Ltd., Zhuhai, Guangdong 519000 (CN); Shandong Aiko Solar Technology Co., Ltd, Jinan, Shandong 250000 (CN); Chuzhou Aiko Solar Technology Co., Ltd., Chuzhou, Anhui 239514 (CN)
(72) Inventor: XU, Yang, Jinhua, Zhejiang 322009 (CN); SUN, Qinkang, Jinhua, Zhejiang 322009 (CN); CHEN, Gang, Jinhua, Zhejiang 322009 (CN)
(74) Representative: Cohausz & Florack
(86) International application number: PCT/CN2025/108230
(87) International publication number: WO 2026/157141

(57) **Abstract**

The present disclosure is applicable to the photovoltaic field. Provided are a photovoltaic cell, assembly and system. On a backlight surface of the photovoltaic cell, a plurality of grid lines and a plurality of microarrays are arranged in a first direction, each of the plurality of grid lines extends in a second direction, each of plurality of the microarrays includes a plurality of arranged microstructure units, and a value of angle α between a microarray and a grid line in the edge region is greater than a value of angle β between a microarray and a grid line in the region near the centerline.

## Description

### Priority Information

The present disclosure claims priority to and the benefit of Chinese Patent Application No. 202510089067.5, filed to the China National Intellectual Property Administration on January 21, 2025, which is incorporated herein by reference in its entirety.

### Technical Field

The present disclosure belongs to the field of photovoltaic technology, and in particular, to a solar cell, a solar assembly and a photovoltaic system.

### Background

In the existing solar cell technology, although various methods have been employed to optimize light absorption and charge transport, there remain certain technical problems that need to be urgently addressed. Firstly, a conventional planar backlight surface design tends to cause direct penetration and light escape, thereby reducing the propagation path of light within the silicon substrate and lowering light absorption efficiency. In addition, the problem of interface state recombination is relatively pronounced, which can significantly affect the passivation performance of the back-surface passivation film, resulting in an increase in surface recombination loss and a consequent reduction in the open-circuit voltage.

Secondly, in the art known to inventors, microstructure units are designed on the backlight surface, which can, to a certain extent, improve light absorption and optimize passivation performance. However, the current microstructure unit designs cannot effectively alter the angle of light, such that part of the light still escapes upon reaching the light-facing surface, thereby reducing the opportunity for light absorption and lowering the photoelectric conversion efficiency.

### Summary

Some embodiments of the present disclosure provide a solar cell, a solar assembly and a photovoltaic system, aiming to solve the problem of low light absorption efficiency of existing solar cells.

The present disclosure is implemented as follows: a solar cell, including:
a silicon substrate, wherein the silicon substrate includes a backlight surface and a light-facing surface opposite to each other; a plurality of grid lines and a plurality of microarrays are arranged on the backlight surface in a first direction; each of the plurality of grid lines extends in a second direction; each of the plurality of microarrays includes a plurality of arranged microstructure units, and an angle is disposed between a microarray and a grid line; the first direction intersects with the second direction; and
a length of the silicon substrate in the second direction is L, and two side edges of the silicon substrate parallel to the first direction respectively extend towards a centerline by a range of L/9, defining an edge region; an angle in the edge region is α, and an angle in a region near the centerline is β, wherein a value of the α is greater than a value of the β.

In some embodiments, a difference between the value of α and the value of β ranges from 1° to 15°.

In some embodiments, a difference between the value of α and the value of β ranges from 2° to 13°.

In some embodiments, a difference between the value of α and the value of β ranges from 4° to 13°.

In some embodiments, some of the plurality of microstructure units are disposed discontinuously.

In some embodiments, the first direction is perpendicular to the second direction.

In some embodiments, the plurality of grid lines are disposed on the backlight surface.

In some embodiments, the plurality of grid lines are in a same polarity.

In some embodiments, the plurality of grid lines include first-polarity grid lines and second-polarity grid lines in different polarities.

In some embodiments, the backlight surface is alternately provided with first doped regions and second doped regions, the first-polarity gate lines are provided on the first doped regions, and the second-polarity gate lines are provided on the second doped regions.

In some embodiments, in the edge region, microarrays within a first doped region are parallel to microarrays within a second doped region adjacent to the first doped region.

In some embodiments, microstructure units on at least one of the first doped regions and the second doped regions are disposed irregularly.

In some embodiments, each of the plurality of microstructure units is with a recessed structure.

In some embodiments, a largest size of the recessed structure within a first doped region is greater than or equal to a largest size of the recessed structure within a second doped region.

In some embodiments, a projection of a bottom surface of the recessed structure in a thickness direction of the cell is a polygon.

In some embodiments, a number of sides of the polygon is at least one of 3 to 6.

In some embodiments, a size of the polygon within the first doped region is 20 µm to 35 µm, and a size of the polygon within the second doped region is 8 µm to 15 µm.

In some embodiments, a depth of the recessed structure in the thickness direction of the cell is 0.2 µm to 2 µm.

In some embodiments, a roughness of each of the first doped regions is less than a roughness of each of the second doped regions.

In some embodiments, a microarray satisfies at least one of the following:
two or more of the plurality of microstructure units are at least partially stacked; and
two or more microstructure units are disposed adjacent to each other in a non-stacked arrangement.

In some embodiments, at least one of the first doped regions and the second doped regions includes one or more of doped polysilicon, doped amorphous silicon, and doped microcrystalline silicon.

Some embodiments of the further present disclosure provide a solar module, including the described solar cell.

Some embodiments of the further present disclosure further provide a photovoltaic system, including the described solar module.

The beneficial effects achieved by the present disclosure are as follows: by providing a microarrays each formed of a plurality of microstructure units, the design of the microstructure units not only facilitates improvement of light absorption, but also exhibits a relatively low interface state recombination, thereby not significantly affecting the passivation performance of the back-surface passivation film. In addition, an angle is disposed between the microarray and the grid line, such that, when light enters the silicon wafer from the light-facing surface, the microstructure units at different angles can change the angle of the light when it is reflected at the backlight surface. Part of the light that would otherwise escape from the silicon wafer is, due to the change in angle, reflected back into the silicon wafer upon reaching the front surface again, which helps to increase the absorption path of light within the silicon wafer, thereby improving light absorption efficiency and ultimately enhancing the current output and overall conversion efficiency of the cell. The value of α in the edge region and the value of β in the region near the centerline further increase the propagation path of light in the silicon wafer, improving the opportunity for light absorption, and thereby further enhancing the photoelectric conversion efficiency of the cell.

### Brief Description of the Drawings

Fig. 1 is a structural diagram of the solar cell provided according to embodiments of the present disclosure;
Fig. 2 is a microscopic view of the angle of α in the edge region of the solar cell provided according to embodiments of the present disclosure;
Fig. 3 is a microscopic view of the angle of β in the region near the centerline of the solar cell provided according to embodiments of the present disclosure;
Fig. 4 is a current trend graph showing different angle differences between the angle of α in the edge region and the angle of β in the region near the centerline;
Fig. 5 is a schematic diagram of the conversion efficiency trend when there are different angle differences between the angle of α in the edge region and the angle of β in the region near the centerline;
Fig. 6 is a schematic diagram of the printing defect rate when there are different angle differences between the angle of α in the edge region and the angle of β in the region near the centerline;
Fig. 7 is a schematic diagram of the scratch rate when there are different angle differences between the angle of α in the edge region and the angle of β in the region near the centerline;
Fig. 8 shows electrical performance data of various group of cells when there are different angle differences between the angle of α in the edge region and the angle of β in the region near the centerline;
Fig. 9 is a schematic diagram of an optical path in a microstructure unit; and
Fig. 10 is a partial microscopic schematic view of a microstructure unit.

### Description of reference signs:

100. solar cell; 110. silicon substrate; 111. first side edge; 112. second side edge; 120. microarray; 121. microstructure unit; 130. grid line.

### Detailed Description of the Embodiments

To make the objectives, technical solutions, and advantages of the present disclosure clearer, hereinafter, the present disclosure will be further described in detail below in conjunction with the accompanying drawings and embodiments. Examples of the embodiments are shown in the accompanying drawings, in which same or similar reference signs represent same or similar elements or elements having same or similar functions. The embodiments described herein with reference to the accompanying drawings are illustrative, and only used to explain the present disclosure, and therefore the embodiments cannot be understood as limitation to the present disclosure. In addition, it should be understood that the specific embodiments described herein are only used to explain the present disclosure, and are not intended to limit the present disclosure.

In the illustration of the present disclosure, it should be understood that orientation or positional relationships indicated by the terms such as "length", "width", "upper", "lower", "left", "right", "horizontal", "top", "bottom", etc. are orientation or positional relationships based on those as shown in the accompanying drawings, are only used to facilitate the illustration of the present disclosure and to simplify the illustration, rather than indicating or implying that an apparatus or element referred to must have a specific orientation, and be constructed and operated in the specific orientation, and therefore said terms cannot be understood as limitation to the present disclosure.

In addition, the terms "first" and "second" are only used for descriptive purposes, and cannot be understood as indicating or implying relative importance or implicitly indicating the number of indicated technical features. Thus, the features defined by "first" and "second" may explicitly or implicitly comprise one or more of the features. In the illustration of some embodiments of the present disclosure, the meaning of "a plurality of" is two or two and more, unless explicitly and specifically defined otherwise.

In the illustration of some embodiments of the present disclosure, it should be noted that unless explicitly specified and limited otherwise, the terms "mount", "connect to", and "connecting" should be understood broadly, and for example, may be fixed connection, and may also be detachable connection, or integral connection; may be mechanical connection, and may also be electrical connection or may be in communication with each other; and may be direct connection, and may also be indirect connection by means of an intermediate medium, and may also be interior communication between two elements, or interaction relationship between two elements. For a person of ordinary skill in the art, the specific meanings of the described terms in the present disclosure could be understood according to specific situations.

In the present disclosure, unless explicitly specified or limited otherwise, a first feature being "above" or "below" a second feature may comprise the first feature being in direct contact with the second feature, and may also comprise the first and second features being not in direct contact but being contacted by another feature between them. Furthermore, a first feature being "over", "above", or "on" a second feature comprises the first feature being directly above or obliquely above the second feature, or merely mean that the first feature having a horizontal height higher than that of the second feature. A first feature being "below", "beneath" or "under" a second feature comprises the first feature being directly below or obliquely below the second feature, or merely mean that the first feature having a horizontal height lower than that of the second feature.

The following disclosure provides many different embodiments or examples for implementing different structures of the present disclosure. In order to simplify the disclosure of the present disclosure, components and arrangements of specific examples are described below. Of course, they are merely examples and are not intended to limit the present disclosure. In addition, the present disclosure may repeat reference signs and/or letters in the various examples for the sake of simplicity and clarity, which do not in itself indicate relationships between the various embodiments and/or arrangements discussed. In addition, the present disclosure provides examples of various specific processes and materials, but one of ordinary skill in the art can recognize applications of other processes and/or use of other materials.

In the present disclosure, by providing a microarray formed of a plurality of microstructure units, the design of the microstructure units not only facilitates improvement of light absorption, but also exhibits a relatively low interface state recombination, thereby not significantly affecting the passivation performance of the back-surface passivation film. In addition, an angle is disposed between each of the microarrays and each of the grid lines, such that, when light enters the silicon wafer from the light-facing surface, the microstructure units at different angles can change the angle of the light when it is reflected at the backlight surface. Part of the light that would otherwise escape from the silicon wafer is, due to the change in angle, reflected back into the silicon wafer upon reaching the front surface again, which helps to increase the absorption path of light within the silicon wafer, thereby improving light absorption efficiency and ultimately enhancing the current output and overall conversion efficiency of the cell. The angle of α in the edge region being greater than the angle of β in the region near the centerline further increases the propagation path of light in the silicon wafer, improving the opportunity for light absorption, and thereby further enhancing the photoelectric conversion efficiency of the cell.

### Embodiment 1

The present embodiment provides a solar cell 100, including:
a silicon substrate 110, the silicon substrate 110 including a backlight surface and a light-facing surface which are disposed opposite to each other, wherein a plurality of microarrays 120 and a plurality of grid lines 130 are arranged on the backlight surface in a first direction, each of the grid lines 130 extends in a second direction, each of the microarrays includes a plurality of microstructure units disposed linearly, an angle is disposed between a linear direction of a microarray 120 and an extension direction of a grid line 130, and the first direction intersects with the second direction; and
a length of the silicon substrate 110 in the second direction is L, and two side edges of the silicon substrate 110 parallel to the first direction respectively extend towards a centerline by a range of L/9, defining an edge region; an angle in the edge region is α, and an angle in a region near the centerline is β, wherein a value of α is greater than a value of β.

The silicon substrate 110 includes two main surfaces, namely a light-facing surface and a backlight surface, where the light-facing surface is a surface directly facing sunlight, the backlight surface is another surface, and the two surfaces are disposed opposite to each other. The back surface of the silicon substrate 110 typically includes alternately arranged N-regions and P-regions, an N-type doped layer is disposed in each N-region, a P-type doped layer is disposed in each P-region, the N-type doped layer and the P-type doped layer form regions with different chemical characteristics, facilitating the formation of a PN junction and the separation of charge carriers.

The plurality of grid lines and the plurality of microarrays are disposed in the first direction respectively, and each grid line extends in the second direction, the second direction intersecting with the first direction. The grid lines may be disposed in a longitudinal direction of the silicon substrate and each extends in a transverse direction, that is, the first direction may be the longitudinal direction of a back contact cell, and the second direction may be the transverse direction of the back contact cell, the two being perpendicular to each other. Certainly, in other embodiments, the first direction and the second direction may also be other directions, for example, the two directions may be diagonal directions of the silicon substrate, which is not specifically limited herein. The plurality of grid lines and the plurality of microarrays are mutually superimposable.

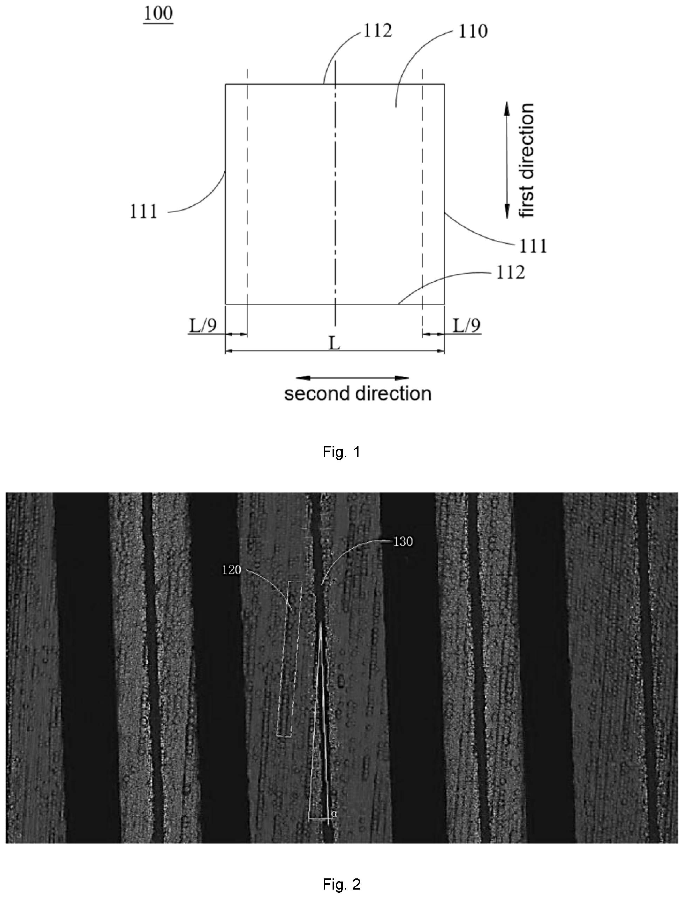

As shown in Fig. 1, the first direction is the longitudinal direction of the silicon substrate 110, and the plurality of microarrays 120 and grid lines 130 are arranged in the first direction on the backlight surface; generally, a grid line 130 is linear and extends in the second direction, and the second direction is perpendicular to the first direction, that is, the grid line extend in the transverse direction of the silicon substrate 110. Each microarray 120 is formed by arranging a plurality of microstructure units 121, where each of the plurality of microstructure units 121 have a small diameter, and the plurality of microstructure units 121 are closely overlapped and arranged to form the microarray 120. Each of the plurality of microstructure units 121 may be in various shapes, such as a pyramid, an inverted pyramid, a micro-hole, or micro-column, which are not limited herein.

It can be understood that an angle between a grid line 130 and a linear direction of the microarray 120 is an angle between the tangent line of a certain position on the microarray 120 and the grid line 130. A specific position is selected on the microarray 120, and then a tangent line is drawn to this position (if the microarray 120 is arranged in a straight line at this position, the tangent direction is consistent with the extension direction of the straight line; and if the microarray 120 is arranged in a curve at this position, the tangent line is the tangent line of the curve). The grid lines 130 themselves are a series of parallel lines having a fixed orientation parallel to two side edges of the cell in the first direction. Each grid line 130 has a certain width; however, when measuring the angle, the width of the grid line 130 is not taken into consideration, and the grid line 130 are approximately regarded as straight lines parallel to the two side edges of the cell in the first direction. In the present disclosure, the tangent line and the grid line 130 are only considered as scalar quantities, regardless of directivity, and the term "angle" in the present disclosure refers to an angle greater than 0° and less than 90°.

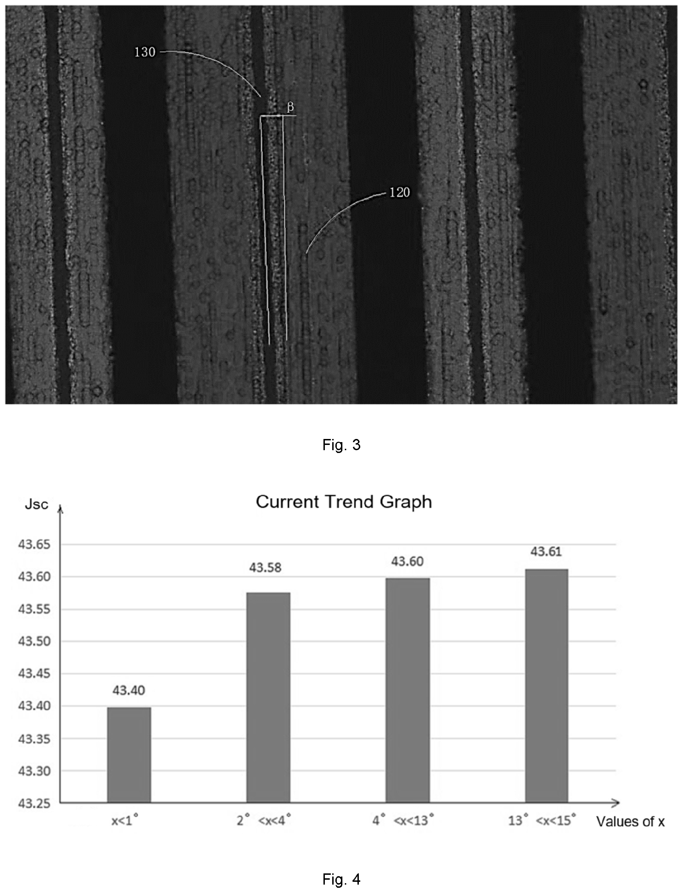

As shown in Figs. 2 and 3, there is an angle between the grid line 130 and the microarray 120. Generally, the silicon substrate 110 is a square, and the grid line 130 is perpendicular to the first direction and parallel to the edge lines of the silicon substrate 110. The first side edges 111 are two opposite side edges of the silicon substrate 110, and the first side edges 111 are parallel to the first direction. The second side edges 112 are two side edges of the silicon substrate 110 connected to the first side edges 111, and the second side edges 112 are perpendicular to the first side edges 111. The region extending from each first side edge 111 of the silicon substrate 110 toward the center by a length of L/9 of the substrate is defined as an edge region. There are two edge regions, oppositely disposed on two sides of the silicon substrate 110. A line at a distance of L/2 from the first side edge 111 is defined as the centerline, with the centerline located between the two edge regions. In the edge region, the angle between the grid line 130 and the microarray 120 is α, and in the region near the centerline, the angle between the grid line 130 and the microarray 120 is β, the value of α being greater than the value of β.

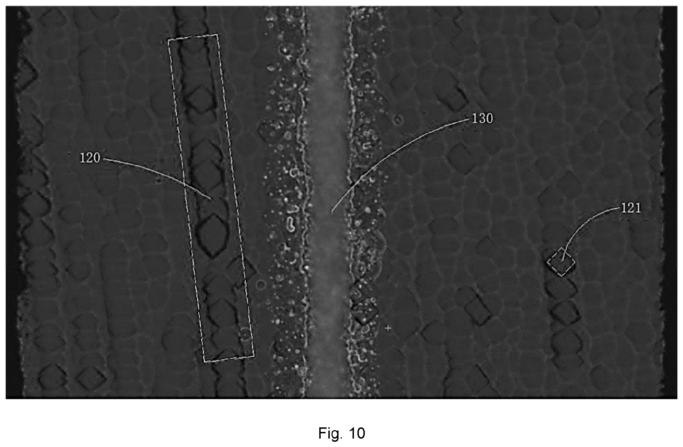

As shown in Fig. 10, the microarray 120 is formed by arranging microstructure units 121, and when light is incident on the microstructure units 121, multiple refractions and reflections occur between a plurality of surfaces, which lengthens a propagation path of the light in the silicon substrate 110, thereby increasing the chance of photons interacting with silicon material. According to different positions of the microstructure units 121, the light may have different refraction effects and reflection effects on the microstructure units 121. The angle between the microarray 120 and the grid line 130 is different, then the microstructure units 121 at the positions are also placed at different angles, and then different light may be refracted and reflected at different angles, which complicates the propagation path of light in the silicon substrate 110, and further lengthens the propagation path of light in the silicon substrate 110, thereby further increasing the chance of interaction between photons and the silicon material, and improving the absorption rate.

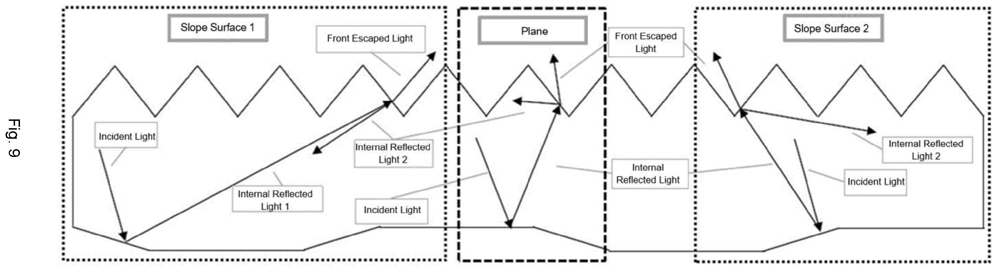

In this embodiment, as shown in Fig. 9, light enters the silicon wafer from the light-facing surface, and the light propagates inside the silicon wafer, and a part of the light is absorbed by the silicon material and converted into electric energy. Unabsorbed light reaches the backlight surface and is reflected by the microarrays 120. The angle of the reflected light changes due to the shape and arrangement of the microstructure units 121, and a part of the light is reflected back into the silicon wafer, thereby increasing the chance of light absorption. In different regions, angles between a grid line 130 and a microarray 120 are different to form a diffuse reflection effect. Diffuse reflection increases the propagation path of light inside the silicon wafer, further enhancing the photoelectric conversion efficiency. After the light reflected back into the silicon wafer is absorbed, the generated electrons and holes are collected by the grid lines 130 to form a current output.

Additionally, if the value of α in the edge region differs from the value of β in the region near the centerline, the microstructure units 121 at corresponding positions are placed at different angles. Microstructure units 121 at different angles can better capture light at various incident angles, reducing light escape, improving overall light capture efficiency, further reducing reflection loss, and enhancing light transmission and absorption efficiency.

In this embodiment, by providing microarrays 120 each formed of a plurality of microstructure units, the design of the microstructure units not only facilitates improved light absorption but also has relatively low interface state recombination, which does not significantly affect the passivation effect of the back-surface passivation film. Meanwhile, there is an angle between the microarray 120 and the grid line 130, and after light enters the silicon wafer from the light-facing surface, the microstructure units 121 at different angles can change the angle of the light when it is reflected from the back surface. Part of the light that would otherwise escape from the silicon wafer is, due to the change in angle, reflected back into the silicon wafer upon reaching the front surface again, which helps to increase the absorption path of light within the silicon wafer, thereby improving light absorption efficiency and ultimately enhancing the current output and overall conversion efficiency of the cell. The value of α in the edge region is greater than the value of β in the region near the centerline, which can further increase the propagation path of light within the silicon wafer, enhance the opportunity for light absorption, and thereby further improve the photoelectric conversion efficiency of the cell.

In some embodiments, the difference between the value of α and the value of β is between 1° and 15°.

If the difference between α and β is smaller than 1°, the difference between the value of α in the edge region and the value of β in the region near the centerline is too small, which cannot achieve a good diffuse reflection effect, and cannot well reduce light escape, and has a small effect on improving the photoelectric conversion efficiency. If the difference between the value of α and the value of β is greater than 15°, the difference between the light incident angles in the edge region and the region near to the centerline is too large, which may result in over optimization of light incident angle in one region and insufficient optimization in the other region. For example, an excessively large angle in the edge region may cause the propagation path of light to become too long, thereby increasing reflection loss; and an excessively small angle between the grid line and the microarray in the region near the centerline may lead to increased direct transmission of light, reducing absorption. In addition, an excessively large angle difference will cause significant variations in the light propagation paths in different regions, leading to uneven light distribution within the silicon substrate 110. This may reduce the overall photoelectric conversion efficiency, as the photon absorption rate in some regions may be significantly higher than in others, resulting in efficiency imbalance.

Therefore, by setting the difference between the value of α and the value of β within the range of 1° to 15°, the incident angles of light between the edge region and the region near the centerline can be optimized, enabling light from different positions to effectively enter the silicon substrate 110 and reducing reflection loss. Within this range, the propagation path length of the light in different regions varies moderately, and the uniform distribution of the light in the silicon substrate 110 can be maintained, thereby improving the overall photoelectric conversion efficiency.

In some embodiments, the difference between the value of α in the edge region and the value of β in the region near the centerline is within the range of 2° to 13°.

In laboratory experiments, when the value of α in the edge region and the value of β in the region near the centerline have different angle differences, relevant electrical performance tests were conducted, and corresponding laboratory data were obtained. A difference between the value of α in the edge region and the value of β in the region near the centerline is x. The experimental data below represent the average values obtained after processing the data from a plurality of tested solar cells. During the experiment, it is inevitable that random factors will introduce errors in individual data points. By averaging the results of multiple experiments, such random errors can be effectively smoothed out, thereby improving the stability of the data.

As shown in Fig. 4, with the increase of the value of x, short circuit current density (Jsc) gradually increases, since the microarray 120 on the backlight surface alters the light transmission path and facilitates light absorption by the cell, thereby generating more photo-generated carriers and increasing the current. However, as the value of x continues to increase, the rate of increase of Jsc gradually decreases, and when the value of x exceeds 13°, the increase in Jsc is only 0.01, which is negligible.

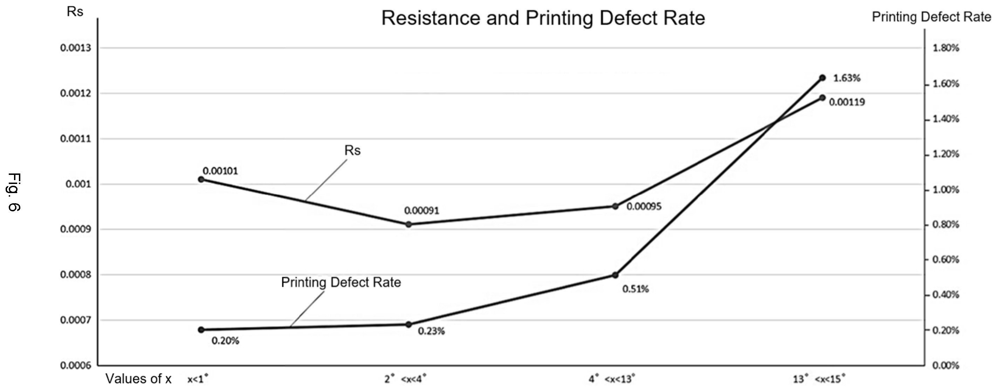

As shown in Fig. 6, with the increase of the value of x, the printing defect rate, such as breakage of fine grid lines, in various groups of solar cells shows an upward trend. When the value of x is less than 13°, the defect rate increases relatively slowly, and when the value of x exceeds 13°, the defect rate rises sharply. Due to the increased occurrence of broken lines, the current collection capability of the grid lines 130 deteriorates, resulting in reduced current gains generated by the microstructures, ultimately causing corresponding changes in the current. When the value of x exceeds 13°, the current significantly decreases.

It can be understood that the increased occurrence of broken lines leads to poorer current collection by the grid lines 130, reducing the current gains generated by the microstructures.

In addition, as the value of x increases, the series resistance (Rs) first decreases, then increases, and subsequently shows a sudden change. The microstructure units 121 increase the surface roughness of the silicon wafer, which improves the contact between the metal paste and the surface of silicon wafer, thereby reducing the series resistance. When the value of x is less than 13°, the printing defect rate of the solar cells is low, leading to a decrease in series resistance and a corresponding increase in the fill factor (FF). When the value of x exceeds 13°, the printing defect rate in the solar cells rises sharply. The increase in series resistance caused by broken or coarse grid lines surpasses the effect of the microstructure units 121, resulting in an overall increase in series resistance and a significant reduction in FF.

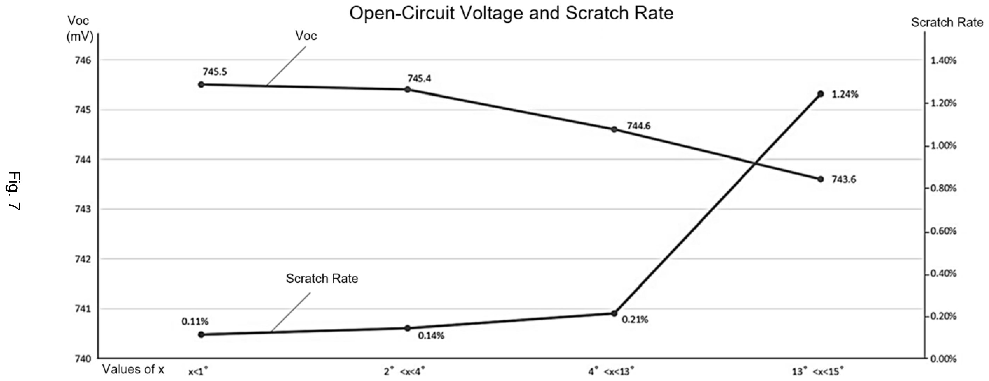

As shown in Fig. 7, with the increase of the value of x, the surface scratch rate on the cells also shows an upward trend, especially when the value of x exceeds 13°, the scratch rate rises sharply. These scratches result from the increased arc angles formed by the microstructures, which increase the surface roughness. Consequently, in the cell manufacturing process, the wafer surface is more prone to scratches when coming into contact with automated equipment or worktables, leading to degraded surface passivation and a reduction in open-circuit voltage (Voc).

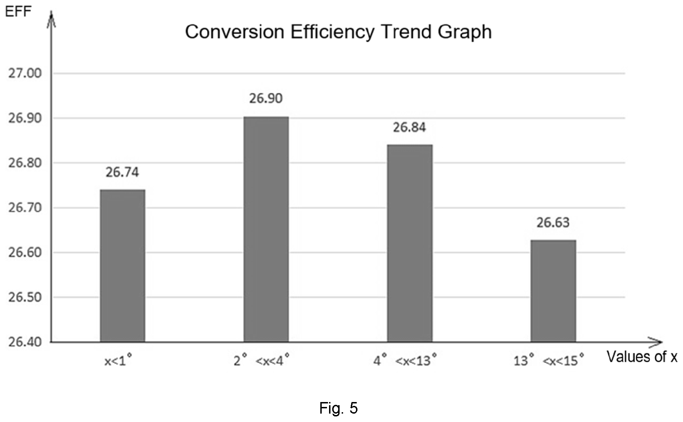

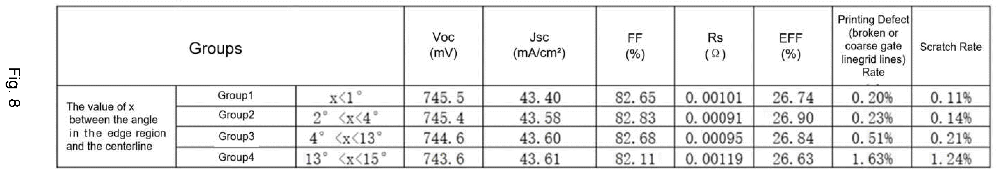

As shown in Figs. 5 and 8, in view of the respective electrical performances, when the value of x is less than 2°, although the values of the printing defect rate and the scratch rate are very low, the values of Voc, Jsc, FF, and conversion efficiency (EFF) are also relatively low. When the value of x is greater than 13°, the printing defect rate and scratch rate become excessively high, and the values of Voc, FF, and EFF are also low, although the value of Jsc increases, the increment is too small. When the value of x is within the range of 2° to 13°, both the printing defect rate and scratch rate remain at relatively low levels, while Voc, Jsc, FF, and EFF all increase significantly.

In this embodiment, the value of x may be 2°, 2.2°, 3°, 3.3°, 4°, 4.5°, 5°, 5.4°, 6°, 6.5°, 7°, 8°, 9°, 10°, 11°, 12°, 13°, or other values within the range of 2° to 13°, with not all examples listed here.

When the angle difference is less than 2°, the optimization effect is limited, and the difference in light incident angles is not significant, the change in light propagation path is minimal, and although the manufacturing difficulty is low, significant performance improvement is difficult to achieve. When the angle difference is greater than 13°, over-optimization occurs, and the light propagation path becomes non-uniform, and the excessive angle difference may affect the stability of the microstructure units 121, making the structure prone to deformation or damage during manufacturing and use, thereby reducing the service life and reliability of the solar cell and leading to an overall efficiency decline. When the angle difference is in the range of 2° to 13°, the optimization effect is favorable, the light incidence angles are relatively moderate, the light propagation paths are relatively uniform, and the structural stability is good, making it an appropriate choice for improving photoelectric conversion efficiency and overall performance.

In this embodiment, as shown in Fig. 8, when the value of x is in the range of 4° to 13°, the values of Voc, Jsc, FF, and EFF increase the most. That is, when the difference between the value of α in the edge region and the value of β in the region near the centerline is in the range of 4° to 13°, the performance of the solar cell 100 can achieve optimal balance under different illumination conditions. This design significantly reduces reflection loss by optimizing the refraction and reflection of light on the microstructure units 121 and grid lines 130, further enhancing photon absorption and photoelectric conversion efficiency.

### Embodiment 2

As shown in Fig. 10, in some embodiments, microstructure units 121 are disposed discontinuously.

The arc-shaped microarrays 120 formed by overlapping a plurality of microstructure units 121 are non-continuous arrangements of the microstructure units 121, that is, some microstructure units 121 are not closely connected with each other due to a certain spacing therebetween. In this embodiment, each of the microstructure units 121 may have different shapes and sizes (usually at a micron level), and the spacing between some microstructure units 121 may also be different.

The discontinuous arrangement of microstructure units 121 makes the reflection path of the light inside the silicon wafer more complex. The light is reflected multiple times between different microstructure units 121, increasing the propagation path of the light in the silicon wafer, thereby improving the light absorption efficiency. Furthermore, due to the spacing between some microstructure units 121, there are more possibilities for the light to be absorbed by the silicon wafer in the reflection process, thereby reducing the amount of escaping light.

### Embodiment 3

In some embodiments, the grid lines are disposed on the backlight surface of the cell.

In a back contact cell, such as an Hetero junction Back Contact Solar Cell (HBC), the grid lines are disposed on the back surface of the cell. There is no grid line blocking the front surface, which maximizes the effective area for absorbing sunlight and improves the photoelectric conversion efficiency of the cell.

In some embodiments, the grid lines have only one polarity. In some cells, all the electrodes (for example, positive grid lines) for collecting current of the front surface are located on the back surface of the cell. This design means that the front surface of the cell is completely free of any metal grid lines, allowing all incident light to reach the photovoltaic material. As a result, more sunlight can directly irradiate the photovoltaic material, thereby improving the light absorption rate and the photoelectric conversion efficiency of the cell.

In some embodiments, the grid lines include first-polarity grid lines and second-polarity grid lines of opposite polarity. Each of the first-polarity grid lines and each of the second-polarity grid lines are in opposite polarities, with one being a positive grid line and the other being a negative grid line. The positive grid lines collect photo-generated electrons, and the negative grid lines collect photo-generated holes. This design can optimize the current path, reduce series resistance, and improve the overall performance of the cell.

In some embodiments, the backlight surface is alternatively provided with first doped regions and second doped regions in the first direction. The first-polarity grid lines are disposed on the first doped regions, and the second-polarity grid lines are disposed on the second doped regions.

On the backlight surface of the silicon substrate 110, two types of different doped regions, namely, the first doped region and the second doped region, are alternately disposed. In this embodiment, a plurality of first doped regions and a plurality of second doped regions are alternately disposed on the first direction, and the first doped regions and the second doped region each extend on the second direction, the second direction intersecting with the first direction. The arrangement direction of the first doped regions and the second doped regions is consistent with the arrangement direction of the grid lines, and the extension direction of each of the first doped regions and each of the second doped regions is consistent with the extension direction of each of the grid lines.

A first doped layer is disposed in the first doped region, a second doped layer is disposed in the second doped region, and the first doped layer and the second doped layer are in different polarities. In this embodiment, the first doped layer may be a P-type doped layer, and the second doped layer may be an N-type doped layer, or, the first doped layer may also be an N-type doped layer, and the second doped layer may be a P-type doped layer. The first doped layer and the second doped layer form doped regions with different electrical characteristics, facilitating the formation of a PN junction and the separation of charge carriers.

The first-polarity grid lines are disposed on the first doped regions, with the polarity of the first-polarity grid lines corresponding to that of the first doped regions. The second-polarity grid lines are disposed on the second doped regions, with the polarity of the second-polarity grid lines corresponding to that of the second doped regions. That is, when each of the first doped regions is a P-type doped layer and each of the second doped region is an N-type doped layer, the first-polarity grid lines are positive grid lines and the second-polarity grid lines are negative grid lines; and when each of the first doped region is an N-type doped layer and each of the second doped region is a P-type doped layer, the first-polarity grid lines are negative grid lines and the second-polarity grid lines are positive grid lines.

In some embodiments, a spacing region is disposed between the first doped region and the second doped region, and the spacing region provides physical isolation between the first doped region and the second doped region, which facilitates forming clearer electric field separation between the first doped region and the second doped region. Optimization of the electric field enhances the separation efficiency of carriers, reduce direct recombination of carriers (electrons and holes) in these regions, decrease recombination loss, and increase the open-circuit voltage.

In some embodiments, in the edge region, the microarrays 120 in a first doped region are parallel to the microarrays 120 in a second doped region adjacent to the first doped region.

The edge region is typically a high-risk area for carrier recombination. In the edge region, arranging the microarrays 120 in the adjacent first doped region and second doped region to be parallel to each other can ensure a more uniform propagation path of light in these regions, reduce the reflection loss of light in the edge region, improve the absorption rate of light, and thereby improve the photoelectric conversion efficiency. Meanwhile, the parallel microarrays 120 can reduce recombination loss in the edge region and reduce the risk for carrier recombination in the edge region.

In some embodiments, the distribution of microstructure units on at least one of the first doped regions and second doped regions are disposed irregularly.

The distribution density and arrangement of the microstructure units in different regions may be different. In a same doped region, the density or arrangement of microstructure units at different positions may be different. For example, all the microstructure units on the first doped region and second doped region are disposed irregularly; or, the microstructure units on the first doped region are disposed irregularly, while the microstructure units on the second doped region are disposed uniformly; or, the microstructure units on the first doped region are disposed uniformly, while the microstructure units on the second doped region are disposed irregularly.

By means of the irregular distribution of microstructure units, the propagation paths of light in different regions can be optimized, and reflection loss at a specific angle can be reduced.

### Embodiment 4

In some embodiments, each of the plurality of microstructure units 121 is with a recessed structure.

Each microstructure unit 121 is recessed from the backlight surface toward the light-facing surface, that is, the distance from the top surface of the microstructure unit 121 to the light-facing surface is smaller than the distance from the backlight surface to the light-facing surface.

The recessed microstructure unit 121 can form a plurality of reflective surfaces, so as to increase multiple reflections of light within these microstructure units 121. Such multiple reflections lengthen the propagation path of light within the silicon substrate 110, improving light absorption efficiency. The recessed structure can further increase the scattering effect of light, such that light is more evenly distributed in the silicon substrate 110, thereby improving the short circuit current density (Jsc). Furthermore, the recessed microstructure units 121 can form an optical waveguide, so that the light propagates along a specific path, thereby reducing the direct penetration and escape of the light, and further improving the light capturing rate.

In some embodiments, the depth of the recessed structure in the thickness direction of the cell is 0.2 µm to 2 µm.

That is, the distance from the bottom surface of the microstructure unit 121 to the backlight surface is 0.2 µm to 2 µm, for example, 0.2 µm, 0.3 µm, 0.4 µm, 0.5 µm, 0.6 µm, 0.7 µm, 0.8 µm, 0.9 µm, 1 µm, 1.2 µm, 1.5 µm, 1.8 µm, and 2 µm, or any other value within the range of 0.2 µm to 2 µm, which is not limited herein. In this depth range, the light transmission and scattering characteristics are optimized, and the performance of the optical material, including light transmittance and reflectivity, is improved.

In some embodiments, the largest size of the recessed structure in the first doped region is greater than or equal to the largest size of the recessed structure in the second doped region.

The recessed structure may be formed by performing chemical etching, laser etching, mechanical method, or plasma etching on the silicon substrate 110. The recessed structure generally forms a plane at the bottom, and the size of the recessed structure may be a length, a width, a diagonal length, or a circle's diameter of the surface, which is not limited herein. In the first doped region and the second doped region, a recessed structure with the largest area in each region is selected for measurement. In some examples, when measuring the size of the recessed structure, the surface of the film layer can be directly measured and calibrated directly by a test instrument (such as optical microscope, atomic force microscope, scanning electron microscope, and transmission electron microscope).

The size of the recessed structure in the first doped region is greater than or equal to the size of the recessed structure in the second doped region. Such a design can optimize the light reflection and electric field distribution of the back surface, increase the absorption path of light, facilitate charge separation and transmission, and reduce surface recombination loss and current leakage.

For example, the first doped region may be an N-type doped region, and the second doped region may be a P-type doped region. Microstructure units 121 of different sizes are designed for different doped regions correspondingly, which can improve the passivation quality of the corresponding regions in a more targeted manner and enhance the contact characteristics with respect to the slurry, so that the prepared solar cell can obtain higher cell conversion efficiency.

In some embodiments, a projection of the bottom surface of the recessed structure in the thickness direction of the cell is a polygon, and the bottom surface of the recessed structure may be a planar, and may also have undulations. The number of sides of the polygon is at least one of 3 to 6. For example, the shape of polygonal planes includes at least one of rhombus, square, trapezoid, approximate rhombus, approximate square, approximate trapezoid, pentagon, and hexagon. For example, all the bottom surfaces may be entirely square, entirely rhombic, partially hexagonal and partially rhombic, or partially trapezoidal, partially approximately square, and partially pentagonal. The foregoing examples are not exhaustive, and other possible combinations are not excluded.

In some embodiments, the size of the polygon in the first doped region is 20 µm to 35 µm, and the size of the polygon in the second doped region is 8 µm to 15 µm.

The size of the polygon in the first doped region may be 20 µm, 21 µm, 22 µm, 23 µm, 24 µm, 25 µm, 25.5 µm, 26 µm, 27 µm, 28 µm, 29 µm, 30 µm, 31 µm, 32 µm, 33 µm, 34 µm, and 35 µm, or may also be any other value of 20 µm to 35 µm, which is not limited herein.

The size of the bottom surface of the microstructure unit 121 in the second doped region may specifically be 8 µm, 9 µm, 10 µm, 10.5 µm, 11 µm, 12 µm, 13 µm, 13.6 µm, and 15 µm, or may also be any other value of 8 µm to 15 µm, which is not limited herein.

Further defining the sizes of the bottom surfaces of the microstructure units 121 in different doped regions facilitates obtaining a higher open-circuit voltage and fill factor, and thereby achieving a higher cell conversion efficiency.

### Embodiment 5

In some embodiments, the roughness of the first doped region is less than the roughness of the second doped region.

The surface of the first doped region is smoother than that of the second doped region, and the smooth region can reduce reflection of light and increase absorption of light. The region with a higher roughness can increase the reflection and scattering of light in the material, and lengthen the path of light in the cell, thereby increasing the probability of absorption of photons. Meanwhile, the region with a higher roughness may provide more surface area, facilitating depositing the passivation layer more uniformly, reduces surface recombination, and improves the service life of the charge carriers. The cooperative use of the two roughness regions helps to improve the photoelectric conversion efficiency and reliability of the cell.

### Embodiment 6

In some embodiments, in a microarray 120, two or more of the microstructure units 121 are at least partially stacked, and/or, two or more microstructure units 121 are disposed adjacent to each other in a non-stacked arrangement.

In this embodiment, one microarray 120 includes two or more at least partially stacked microstructure units 121, that is, at least two microstructure units 121 are partially stacked or fully overlapped. Alternatively, one microarray 120 includes two or more microstructure units 121 disposed adjacent to each other in a non-stacked arrangement, that is, at least two microstructure units 121 are adjacent to each other but not overlapped or stacked. Still alternatively, one microarray 120 not only includes two or more at least partially stacked microstructure units 121, but also includes two or more microstructure units 121 adjacent to each other and disposed in a non-stacked arrangement.

It will be appreciated that when the microarray 120 includes two or more at least partially stacked microstructure units 121 and two or more adjacent to each other but non-stacked microstructure units 121, the roughness of the microarray 120 can be controlled within a required range, which is advantageous for enhancing the contact of slurry at conductive regions during the screen-printing process of the solar cell, increasing the tension of the slurry, improving the quality and yield of the solar cell, increasing the open-circuit voltage of the solar cell, and improving the fill factor, thereby increasing the photoelectric conversion efficiency.

### Embodiment 7

In some embodiments, at least one of the first doped regions and the second doped regions includes one or more of doped polysilicon, doped amorphous silicon, and doped microcrystalline silicon.

The polysilicon consists of many small grains, and boundaries between the grains will increase the probability of recombination of electrons and holes. The doping of polysilicon is relatively uniform, because the diffusion of dopants between the grains is relatively consistent. The amorphous silicon does not have a long-range ordered lattice structure, and a large number of dangling bonds and defects are present inside the material. The amorphous silicon exhibits a relatively high nonuniformity in doping, as defects and dangling bonds may affect the distribution of dopants. The microcrystalline silicon structure lies between the amorphous silicon and the polysilicon, including a certain grain structure but with relatively small grain sizes. Microcrystalline silicon has a lower defect density than amorphous silicon, but higher than polysilicon.

According to different types of cells, the doping types of the first doped regions and the second doped regions are selected, and the performance of the solar cell is further optimized by means of a composite design.

In some embodiments, the back surface of the solar cell further includes a passivation contact structure, wherein the passivation contact structure includes an interface tunneling passivation film layer and a doped polysilicon film layer.

The interface tunneling passivation film layer is a very thin film layer (typically between several nanometers and tens of nanometers), and common materials include SiO₂, SiNₓ, Al₂O₃, which are used for passivating a silicon surface to reduce surface recombination.

The doped polysilicon film layer is a thicker polysilicon film layer (typically between several hundreds of nanometers and several micrometers), and a good electrical contact is formed by doping (typically phosphorus or boron), while a long charge carrier service life is maintained.

The passivation contact structure may be a stacked arrangement of an interface tunneling passivation film layer and a doped polysilicon film layer, and may also be that another film layer is disposed between the tunneling passivation film layer and the doped polysilicon film layer. The passivation contact structure helps to improve the photoelectric conversion efficiency and stability of the cell.

In some embodiments, a back surface passivation film layer structure is further included, wherein the material of the back surface passivation film layer structure includes aluminum oxide.

The back surface passivation film layer structure serves to further reduce the surface recombination of the back surface. Aluminum oxide (Al₂O₃) is a very effective passivation material. Aluminum oxide has a relatively high dielectric constant and good electrical insulation performance, and can form effective electrical isolation on the back surface of a cell, thereby reducing current loss. Furthermore, aluminum oxide has very good chemical stability, which can resist the influence of high temperature and humid and warm environment, and improve the durability and reliability of the cell. Meanwhile, the aluminum oxide can effectively reduce the recombination of the silicon surface.

### Embodiment 8

This embodiment provides a solar assembly, including the solar cell 100 in the foregoing embodiments.

The solar assembly may include a plurality of solar cells 100. The plurality of solar cells 100 in the solar assembly may be connected together in series sequentially to form a cell string. Each cell string may be connected in series, parallel, or a combination of series and parallel to achieve current convergence output. For example, the connection between the individual cells may be achieved by means of soldering solder ribbons, and the connection between the individual cell strings may be achieved by means of bus bars.

The solar assembly may further include a metal frame, a backsheet, a photovoltaic glass, and adhesive films (none of which are shown). The adhesive films may be filled between the front surface of the solar cell 100 and the photovoltaic glass, between the back surface and the backsheet, as well as between adjacent cells. As a filler, the adhesive film may be a transparent colloid with good light transmittance performance and ageing resistance performance. For example, an Ethylene Vinyl Acetate Copolymer (EVA) adhesive film or a Polyolefin elastomer (POE) adhesive film may be used as the adhesive film, which may be selected according to actual situations, and is not limited herein.

The photovoltaic glass can cover the adhesive film on the front surface of the solar cell 100. The photovoltaic glass can be super-white glass, has high light transmittance and high transparency, and has superior physical, mechanical and optical performances. For example, the light transmittance of the super-white glass can be up to 92% or more, and can protect the solar cell 100 without affecting the efficiency of the solar cell 100 as far as possible. Moreover, the adhesive film can bond the photovoltaic glass and the solar cell 100 together, and the presence of the adhesive film can seal and insulate the solar cell 100 and protect it from water and moisture.

The backsheet can be attached to the adhesive film on the back surface of the solar cell 100. The backsheet can protect and support the solar cell 100, and has reliable insulation, water resistance and aging resistance performances. The backsheet may have multiple options and is typically made of tempered glass, organic glass, aluminum alloy, or TPT composite adhesive film. The specific choice can be determined based on actual conditions, which is not limited herein. The backsheet, the solar cell 100, the adhesive film and the photovoltaic glass as a whole can be disposed on the metal frame, and the metal frame serves as a main external support structure of the whole solar assembly, and can stably support and mount the solar assembly, for example, the solar assembly can be mounted at a position required to be mounted by means of the metal frame.

The solar assembly of the present embodiment has the same beneficial effects as the described solar cell 100, and will not be described herein.

### Embodiment 9

This embodiment provides a photovoltaic system, including the solar assembly in the forgoing embodiments.

The photovoltaic system can be applied in photovoltaic power stations, such as ground-mounted power stations, rooftop power stations, and floating power stations, and can also be applied to equipment or devices that use solar energy for power generation, such as household solar power supplies, solar street lights, solar vehicles, and solar buildings. It is understood that the application scenarios of the photovoltaic system are not limited thereto, that is, the photovoltaic system can be applied in all fields where solar energy is utilized for power generation. Taking a photovoltaic power generation system network as an example, the photovoltaic system may include a photovoltaic array, a combiner box, and an inverter. The photovoltaic array may be an array combination of multiple cell assemblys. For example, multiple cell assemblys may form multiple photovoltaic arrays. The photovoltaic arrays are connected to the combiner box, which combines the current generated by the photovoltaic arrays. After the combined current flows through the inverter and is converted into alternating current that meets the requirements of the utility power grid, it is fed into the utility network to realize solar power supply.

The beneficial effect of the photovoltaic assembly of the present embodiment is equivalent to that of the described solar assembly, and will not be described herein.

The content above merely relates to preferred embodiments of the present disclosure, and is not intended to limit the present disclosure. Any modifications, equivalent replacements, improvements, etc. made within the spirit and principle of the present disclosure shall all fall within the scope of protection of the present disclosure.

## Claims

1. A solar cell, comprising:
a silicon substrate, wherein the silicon substrate comprises a backlight surface and a light-facing surface opposite to each other; a plurality of grid lines and a plurality of microarrays are arranged on the backlight surface in a first direction; each of the plurality of grid lines extends in a second direction; each of the plurality of microarrays comprises a plurality of arranged microstructure units, and an angle is disposed between a microarray and a grid line; the first direction intersects with the second direction; and
a length of the silicon substrate in the second direction is L, and two side edges of the silicon substrate parallel to the first direction respectively extend towards a centerline by a range of L/9, defining an edge region; an angle in the edge region is α, and an angle in a region near the centerline is β, wherein a value of the α is greater than a value of the β.

2. The solar cell as claimed in claim 1, wherein a difference between the value of α and the value of β ranges from 1° to 15°.

3. The solar cell as claimed in claim 1, wherein a difference between the value of α and the value of β ranges from 2° to 13°.

4. The solar cell as claimed in claim 1, wherein a difference between the value of α and the value of β ranges from 4° to 13°.

5. The solar cell as claimed in claim 1, wherein some of the plurality of microstructure units are disposed discontinuously.

6. The solar cell as claimed in claim 1, wherein the first direction is perpendicular to the second direction.

7. The solar cell as claimed in claim 1, wherein the plurality of grid lines are disposed on the backlight surface.

8. The solar cell as claimed in claim 7, wherein the plurality of grid lines are in a same polarity.

9. The solar cell as claimed in claim 7, wherein the plurality of grid lines comprise first-polarity grid lines and second-polarity grid lines in different polarities.

10. The solar cell as claimed in claim 9, wherein the backlight surface is alternately provided with first doped regions and second doped regions, the first-polarity gate lines are provided on the first doped regions, and the second-polarity gate lines are provided on the second doped regions.

11. The solar cell as claimed in claim 10, wherein in the edge region, microarrays within a first doped region are parallel to microarrays within a second doped region adjacent to the first doped region.

12. The solar cell as claimed in claim 10, wherein microstructure units on at least one of the first doped regions and the second doped regions are disposed irregularly.

13. The solar cell as claimed in claim 10, wherein each of the plurality of microstructure units is with a recessed structure.

14. The solar cell as claimed in claim 13, wherein a largest size of the recessed structure within a first doped region is greater than or equal to a largest size of the recessed structure within a second doped region.

15. The solar cell as claimed in claim 13, wherein a projection of a bottom surface of the recessed structure in a thickness direction of the cell is a polygon.

16. The solar cell as claimed in claim 15, wherein a number of sides of the polygon is at least one of 3 to 6.

17. The solar cell as claimed in claim 15, wherein a size of the polygon within the first doped region is 20 µm to 35 µm, and a size of the polygon within the second doped region is 8 µm to 15 µm.

18. The solar cell as claimed in claim 13, wherein a depth of the recessed structure in the thickness direction of the cell is 0.2 µm to 2 µm.

19. The solar cell as claimed in claim 10, wherein a roughness of each of the first doped regions is less than a roughness of each of the second doped regions.

20. The solar cell as claimed in claim 1, wherein a microarray satisfies at least one of the following:
two or more of the plurality of microstructure units are at least partially stacked; and
two or more microstructure units are disposed adjacent to each other in a non-stacked arrangement.

21. The solar cell as claimed in claim 10, wherein at least one of the first doped regions and the second doped regions comprises one or more of doped polysilicon, doped amorphous silicon, and doped microcrystalline silicon.

22. A cell assembly, comprising the solar cell as claimed in any one of claims 1 to 21.

23. A photovoltaic system, comprising the cell assembly as claimed in claim 22.
